(19) Europäisches Patentamt
European Patent Office
Office européen des brevets

(11) EP 2 592 772 A1

(12) **EUROPEAN PATENT APPLICATION**

(43) Date of publication:
**15.05.2013 Bulletin 2013/20**

(21) Application number: **11188627.1**

(22) Date of filing: **10.11.2011**

(51) Int Cl.:
***H04L 1/00*** *(2006.01)* ***H03M 13/27*** *(2006.01)*
***H04L 27/34*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Panasonic Corporation**
**Kadoma-shi**
**Osaka 571-8501 (JP)**

(72) Inventor: **Petrov, Mihail**
**63225 Langen (DE)**

(74) Representative: **Grünecker, Kinkeldey, Stockmair & Schwanhäusser**
**Leopoldstrasse 4**
**80802 München (DE)**

(54) **Improved time diversity for rotated constellations**

(57) The present invention provides methods, transmitters, and receivers for digital communication systems with improved time diversity for rotated QAM constellations in two or more dimensions. This is achieved by spreading the components of each constellation block evenly over time so that the temporal distance between components of the same constellation block is maximized. Specific implementations of a permutation that is to be applied to the cells of a forward-error-correction block are disclosed.

Fig. 4

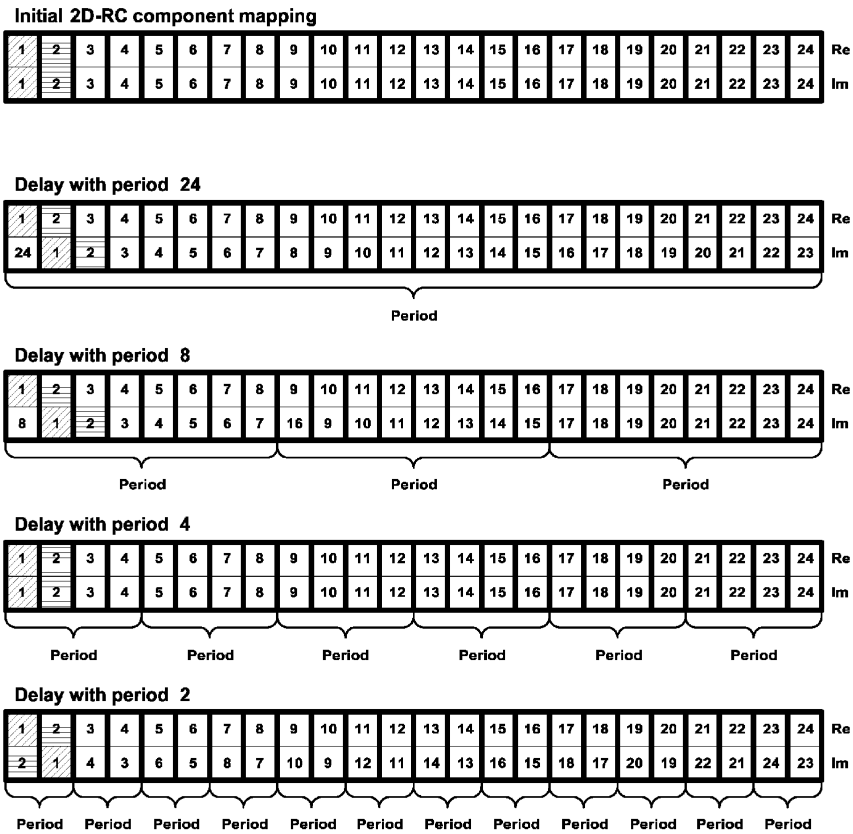


EP 2 592 772 A1

Printed by Jouve, 75001 PARIS (FR)

## Description

TECHNICAL FIELD

The present invention relates to the field of digital communications, and more specifically to improving the time diversity for rotated QAM constellations in two or more dimensions, as well as to corresponding methods, transmitters, and receivers.

BACKGROUND OF THE INVENTION

Figure 1 shows the block diagram of a transmitter-side communication chain that employs rotated quadrature amplitude modulation (QAM) constellations. The transmitter 100 receives at its input binary blocks of a predetermined length, which contain the information to be transmitted.

Each information block is first encoded by a forward-error-correction (FEC) encoder 110. The encoding process consists of adding redundancy in order to make the decoding of the information block in the receiver more robust against errors. Two notable examples of FEC code families are the low-density parity-check (LDPC) codes and the turbo codes. However, the FEC code type is not relevant for the present invention. The most important parameter of the FEC code is its code rate, which is defined as the ratio between the number of information bits and the number of coded bits.

The bits of the encoded FEC codeword, thereafter referred to as FEC block, are demultiplexed at demultiplexer 115 into groups of *B* bits, which are then mapped by PAM mapper 120 onto real-valued pulse amplitude modulation (PAM) symbols, each taking a value from a discrete set of $2^B$ values. How the *B* bits are mapped to PAM symbols is well understood and not directly relevant to the present invention. The relevant aspect is that each block of information bits is transformed into a block of PAM symbols. In the following, the number of PAM symbols per FEC block will be denoted by $N_S$.

Prior to being mapped to PAM symbols, the FEC block may undergo additional processing steps, such as bit permutation or puncturing. These aspects are well known in the art.

The real-valued PAM symbols produced by the PAM mapper 120 are then demultiplexed by demultiplexer 125 into vectors of D symbols each. These vectors can be regarded as identifying unique points in a *D*-dimensional space, the resulting $(2^B)^D$ combinations forming a multi-dimensional constellation. Each vector is then multiplied by an orthogonal *D*x*D* matrix 130. This matrix multiplication can be regarded as a generalized rotation in the *D*-dimensional space, hence the term rotated constellations. The particular structure of the rotation matrix is not relevant to the present invention. The use of rotated constellations is explained in greater detail in European patent application EP 2288048A, which is incorporated herewith in its entirety.

Preferably, D is a power of 2, in particular 2 or 4 or 8. Typically $N_S$ is a multiple of D. If this is not the case, the last 0 to *D*-1 symbols can be left unchanged, i.e. non-rotated. This affects none of the aspects of the present invention. It is also preferred that $N_S$ is a multiple of 2.

In the following, the rotated vectors of D real-valued symbols will be referred to as constellation blocks and the real symbols as components or dimensions.

After the rotation step, the $N_S$ real symbols of each FEC block are mapped to $N_C=N_S/2$ complex symbols, which are also known as complex cells or simply cells. This function is performed by cell mapper 140 in Figure 1. In order to increase the time diversity of the system, the $N_C$ cells of each FEC block are spread in time, typically through interleaving. This function is performed by frame interleaver 160.

This interleaver may be a block interleaver, a convolutional interleaver, or a combination of both. In the DVB-T2 standard for example, the frame interleaver is a block interleaver and is referred to as time interleaver.

The time diversity of the system increases with the interleaving duration, which should be maximized. Very long interleaving durations, however, lead to high latency, slow initial acquisition (e.g. for TV channel zapping), and high memory requirements in both the transmitter and the receiver.

Typically, the transmitted signal is organized in frames of identical duration. The $N_C$ cells of each FEC block can be transmitted in one or a plurality of frames $N_F$. Preferably, the number of cells in each frame is the same. Within a frame, the cells can be transmitted in a single burst or interleaved with other cells over a longer duration. Spreading the cells over the entire frame provides the best diversity and robustness. The exact strategy for frame interleaving and frame mapping is not relevant to the present invention, however.

The interleaved and mapped complex cells are further processed by a chain comprising at least a modulator 180, an up-converter from digital baseband to analog RF, and a radio-frequency RF power amplifier (not shown). The modulator uses e.g. orthogonal frequency-division multiplexing (OFDM) modulation and may include frequency interleaving for increased frequency diversity.

Figs. 2A to 2E show examples of possible combinations of frame interleaving and frame mapping. In these figures, the horizontal and the vertical axis represent time and frequency, respectively.

Figure 2A shows the case when a FEC block is transmitted in a small portion of a frame. The resulting time diversity is low. If that region of the frame is affected by e.g. impulsive noise, all the cells of the FEC block will be affected and the FEC block may no longer be decodable.

Figure 2B shows the case when a FEC block is transmitted as two bursts over a frame, which improves the time diversity. The two bursts are also referred to as slices.

Figure 2C shows the case when a FEC block is spread over an entire frame. The time diversity increases significantly. If an impulsive noise destroys e.g. the beginning of the frame, only a part of the cells in the FEC block will be affected, which reduces the probability of decoding failure.

Figure 2D shows the case when each FEC block is interleaved and spread over two adjacent frames. The time diversity improves, but the required memory for interleaving and deinterleaving doubles in size.

Figure 2E shows the case when each FEC block is interleaved and spread over two non-adjacent frames with a gap of one frame in between. In each of the two frames the cells are transmitted as short bursts. This is known as time slicing and allows the receiver to save power between bursts. The interleaving period is four frames, which further increases the amount of memory required for interleaving and deinterleaving.

Generally, the time diversity may be maximized by (i) transmitting the cells of a FEC block in multiple frames and (ii) spreading the cells in each frame over as much of the frame duration as possible. These two aspects are referred to as inter-frame time diversity and intra-frame time diversity, respectively.

A conventional solution for maximizing time diversity is known from the DVB-T2 standard (ETSI EN 302 755) for rotated constellations in two dimensions. The conventional solution comprises the following steps:

1. Apply a 2D rotation between the real and imaginary components of each complex cell.

2. Apply a relative cyclic delay of one cell between the real and the imaginary components of the $N_C$ cells in each FEC block.

3. Apply a pseudo-random permutation to the cells of each FEC block. The corresponding block in DVB-T2 is known as cell interleaver.

Further details on the above steps are disclosed in the document ETSI EN 302 755 V1.1.1 (2009-09), available at http://www.etsi.org and incorporated herein by reference.

The conventional solution reduces the average correlation of the fading experienced by the two dimensions of each constellation. However, due to the random nature of the permutation, some components of the same constellation block may end up very close to each other while some other components may end up very far from each other. Therefore, time diversity of the conventional solution is not optimal.

## SUMMARY OF THE INVENTION

It is an object of the present invention to further improve the time diversity in a digital communication system. Specifically, it is an object of the present invention to further minimize the average correlation of fading experienced by the components of each constellation block.

This is achieved by the features as set forth in the independent claims. Preferred embodiments are the subject matter of dependent claims.

It is the particular approach of the present invention to ensure that the distance between any two components of a constellation block is maximized and roughly the same for all constellation blocks.

According to a first aspect of the present invention, a method for transmitting digital data is provided. The method comprises the steps of encoding a block of data with a forward error correction code; mapping the encoded block of data to a sequence of real-valued symbols, the sequence of real-valued symbols being divided into a plurality of *D*-dimensional vectors; transforming each of the *D*-dimensional vectors by multiplying the vector with an orthogonal matrix, resulting in a plurality of constellation blocks, each constellation block consisting of D real-valued transformed symbols; mapping the real-valued transformed symbols of the plurality of constellation blocks to a sequence of complex symbols such that the D real-valued transformed symbols of each constellation block are essentially evenly distributed over the sequence of complex symbols; and transmitting the sequence of complex symbols.

Preferably, the sequence of complex symbols is transmitted such that any two consecutive complex symbols of the sequence of complex symbols are transmitted either simultaneously or in the stated order. In other words, the transmission process does not alter the order of the complex symbols.

Preferably, the mapping of the real-valued transformed symbols to the sequence of complex symbols is performed such that a minimum distance between complex symbols with symbols of the same constellation block is, with at most one exception, the same for all constellation blocks. In this manner, the distance between components of the same constellation block can be maximized simultaneously for all constellation blocks — and, therewith, the time diversity.

In a preferred embodiment, the step of mapping the real-valued transformed symbols to the sequence of complex symbols is performed by mapping the D real-valued transformed symbols of each constellation block to D adjacent complex cells, and applying a permutation to the sequence of complex symbols, said permutation being equivalent to writing the sequence of complex symbols into a matrix with D rows column by column and reading out the complex symbols row by row.

In another preferred embodiment with D=2, the step of mapping the real-valued transformed symbols to the sequence of complex symbols is performed by mapping the two real-valued transformed symbols of each constellation block to one complex cell, and applying a cyclic shift to either the real or the imaginary components of the sequence of complex symbols such that the real and the imaginary components are rotated relative to each other by a certain number of complex symbols, the certain number of complex symbols being equal to half the number of complex symbols within the sequence of complex symbols.

Further, the sequence of complex symbols may be divided into a plurality of $N_F$ slices and the sequence of complex symbols may be mapped to $N_F$ consecutive frames such that all complex symbols of a given slice are mapped to the same frame. In this case, a number of complex symbols per slice differs preferably by at most one among the plurality of $N_F$ slices such that all slices consist of essentially the same number of complex symbols. Hence, the inter-frame diversity will be increased.

According to a further aspect of the present invention, a method for receiving digital data is provided. The method comprises the steps of receiving a sequence of complex symbols; demapping a plurality of constellation blocks from the sequence of complex symbols, each constellation block consisting of D real-valued symbols, the D real-valued symbols of each constellation block being essentially evenly distributed over the sequence of complex symbols; demapping an encoded block of data from the sequence of real-valued symbols; and subjecting the encoded block of data to forward error correction decoding.

Preferably, each real-valued symbol indicates one of a plurality of predefined pulse amplitude modulation symbols. Furthermore, D is preferably a power of 2, in particular 2 or 4 or 8.

According to a further aspect of the present invention, a transmitter for transmitting digital data in a frame-based communication system is provided. The transmitter comprises an encoder for encoding a block of data with a forward error correction code; a symbol mapper for mapping the encoded block of data to a sequence of real-valued symbols, the sequence of real-valued symbols being divided into a plurality of *D*-dimensional vectors; a transform unit for transforming each of the *D*-dimensional vectors by multiplying the vector with an orthogonal matrix, resulting in a plurality of constellation blocks, each constellation block consisting of D real-valued transformed symbols; a cell mapper for mapping the real-valued transformed symbols of the plurality of constellation blocks to a sequence of complex symbols; a cell interleaver for permuting the sequence of complex symbols such that the D real-valued transformed symbols of each constellation block are essentially evenly distributed over the permuted sequence of complex symbols; and a modulator for transmitting the permuted sequence of complex symbols.

According to a further aspect of the present invention, a receiver for receiving digital data is provided. The receiver comprises a demodulator for receiving a sequence of complex symbols from one or more frames; a cell deinterleaver and demapper for demapping a plurality of constellation blocks from the sequence of complex symbols, each constellation block consisting of D real-valued symbols, the D real-valued symbols of each constellation block being essentially evenly distributed over the sequence of complex symbols; a constellation demapper for demapping an encoded block of data from the sequence of real-valued symbols; and a decoder for subjecting the encoded block of data to forward error correction decoding.

The above and other objects and features of the present invention will become more apparent from the following description and preferred embodiments given in conjunction with the accompanying drawings, in which:

Fig. 1 shows a block diagram of a transmitter employing rotated constellation;

Fig. 2A shows an example of combining frame interleaving and frame mapping;

Fig. 2B shows another example of combining frame interleaving and frame mapping;

Fig. 2C shows another example of combining frame interleaving and frame mapping;

Fig. 2D shows another example of combining frame interleaving and frame mapping;

Fig. 2E shows another example of combining frame interleaving and frame mapping;

Fig. 3A illustrates a scheme for FEC block spreading over one frame in accordance with an embodiment of the present invention;

Fig. 3B illustrates a scheme for FEC block spreading over two frames in accordance with an embodiment of the present invention;

Fig. 3C illustrates a scheme for FEC block spreading over three frames in accordance with an embodiment of the present invention;

Fig. 3D illustrates a scheme for FEC block spreading over four frames in accordance with an embodiment of the present invention;

Fig. 4 shows a mapping for two-dimensional rotated constellations with various delay periods;

Fig. 5 shows exemplary component mappings for four-dimensional rotated constellations with various delay periods;

Fig. 6 shows exemplary component mappings with pairing for two-dimensional and four-dimensional rotated constellations;

Fig. 7A is an illustration of the preferred cell permutation for two-dimensional constellations;

Fig. 7B is an illustration of the preferred cell permutation for four-dimensional constellations;

Fig. 8A shows the resulting mapping of the constellation components after the permutation step for two-dimensional rotated constellations;

Fig. 8B shows the resulting mapping of the constellation components after the permutation step for four-dimensional rotated constellations;

Fig. 9 illustrates the slicing of a FEC block over 2, 3, and 4 frames for two-dimensional rotated constellations;

Fig. 10 illustrates the slicing of a FEC block over 2, 3, and 4 frames for four-dimensional rotated constellations;

Fig. 11 is a block diagram of a preferred embodiment of a convolutional interleaver;

Fig. 12 illustrates the spreading of each FEC block over three frames using the convolutional interleaver of Fig. 11;

Fig. 13 illustrates the splitting of a FEC block into interleaving units and slices; and

Fig. 14 is a block diagram of a receiver employing rotated constellation.

## DETAILED DESCRIPTION

In a communication system that employs rotated constellations, it is important that the components of a constellation block experience uncorrelated channel fading. Therefore, the *D* components are preferably mapped to *D* different complex cells and the channel fading experienced by these cells should be as uncorrelated as possible. In this way, the gain of the rotated constellations, and thus the performance of the system, is maximized.

In the general case of rotated constellations in *D* dimensions, the inventor has realized that the best performance is obtained if the time intervals (distances) between two components of the same constellation block are as evenly distributed as possible and as large as possible, for all constellation blocks of a FEC block.

When a FEC block is spread over several frames ($N_F$>1), the *D* dimensions of each constellation block must be distributed as evenly as possible among the $N_F$ frames. If *D* is larger than $N_F$ some frames will carry more than one component from some constellation blocks. In that case, these components must be spread over the frame as evenly as possible.

The present invention ensures that all these conditions can be easily fulfilled.

In Figs. 3A to 3D, several examples are provided in order to illustrate these points. These examples illustrate the mapping of the *D* real components (shown as squares) of a constellation block. Specifically, Figs. 3A, 3B, 3C, and 3D show the ideal mapping in case of a FEC block being spread over one, two, three, and four frames, respectively, both for 2D rotated constellations (2D-RC) and 4D rotated constellations (4D-RC).

In the case of a 2D-RC spread over four frames, it can be easily seen that mapping component pairs on frames 1&3 and 2&4 is the best solution since it ensures that the time interval between the two components of any constellation is 2 frames. Mapping on frames 1&2 and 3&4 also results in an even distribution but the time interval is only 1 frame. Mapping on frames 1&4 and 2&3 is not good because the time interval is 2 on average but it is not the same for all constellation blocks, being either 1 or 3 frames.

In the following, a method for achieving the ideal spreading is described. As an example, a FEC block containing 24 complex cells, as well as 2D and 4D rotated constellations, are considered.

In a first step, the $D$ components of each constellation block are mapped onto $D$ adjacent complex cells. This can be achieved in several ways and the details are not relevant for the present invention.

For example, each constellation block may be mapped onto D/2 adjacent complex cells and a relative delay of $D/2$ symbols between the real and the imaginary components of the complex cells may be inserted. The relative delay is cyclical, with a specified period, which is, however, not important for the present invention. Fig. 4, for instance, shows the resulting mapping for 2D-RC with delay periods 24, 8, 4, and 2. Likewise, Fig. 5 shows the mapping for 4D-RC with delay periods 24, 8, and 4. For obvious reasons, a period of 2 is not possible in the latter case. In general, the delay period must be a multiple of $D$ and a divisor of $N_C$.

Alternatively, each pair of constellation blocks may be mapped onto $D$ adjacent cells. This is equivalent to a delay period of $D$. One block may be mapped onto the real components, and the other onto the imaginary components of the $D$ cells, as illustrated in Fig. 6 for 2D-RC and 4D-RC.

In a second step, a permutation is applied to the cells of the resulting FEC block so that the $D$ components of each constellation block are evenly spread over the entire FEC block. The relevant parameters here are the number of cells per FEC block $N_C$ and the number of dimensions $D$. This permutation corresponds to the pseudo-random cell permutation in the DVB-T2 standard. Unlike a pseudo-random permutation, the permutation according to the present invention ensures an even spreading of the $D$ constellation components, thereby improving the performance of the rotated constellation.

In a preferred embodiment of the present invention, a specific permutation for permuting the cells of the FEC block is provided. The preferred permutation is equivalent to writing the $N_C$ cells of the FEC block into a matrix with $D$ rows column by columns and reading out the cells row by row. This is illustrated in Figs. 7A and 7B for 2D-RC and 4D-RC, respectively. Here, the numbered squares correspond to complex cells rather than to constellation components.

In case $N_C$ is not a divisor of $D$ the last column will be incomplete. Since $N_C$ is always a multiple of $D/2$, however, only $D/2$ cells can be missing in the last column, i.e. half the column. The number of columns is ceil($N_C/D$).

The same permutation may also be expressed in mathematical terms. When $N_C$ is a multiple of $D$, the output cell index $j$ can be expressed as a function of the input cell index i as follows.

$$j = \mathrm{rem}(i,\ D) * N_C/D + \mathrm{floor}(i/D);\ \text{where } i,\ j \text{ are in the interval } 0 \ldots N_C\text{-}1.$$

After applying this permutation, the resulting FEC block will consists of $D$ contiguous regions, each region containing one component from each constellation block. The distance between the components of a constellation block is $N_C/D$ or $N_C/D$-1, i.e. the spreading is as even as possible.

Fig. 8 shows the resulting mapping of the constellation components after the permutation step for 2D-RC and 4D-RC, when a cyclic delay with a period of 24 cells (maximum) is used. The even spread of the $D$ components over the entire FEC block is apparent for all constellation blocks, i.e., a minimum distance between complex symbols with symbols of the same constellation block is, with at most one exception, the same for all constellation blocks. For 2D-RC, the minimum distance is 12 cells with the only exception of the 24$^{th}$ constellation block, having a distance of 23 cells. For 4D-RC, the minimum distance is 6 cells with no exception.

In a third step, the permuted FEC block is mapped to one or more frames, in sequential order. If the FEC block is spread over multiple frames $N_F$ it will be first divided into $N_F$ contiguous slices and each slice will be mapped to exactly one of the $N_F$ frames. Preferably, the $N_F$ slices are of equal size in order to ensure optimum time diversity.

Figs. 9 and 10 show the slicing of the FEC block over two, three, and four frames, for 2D-RC and 4D-RC, respectively. The spreading of the $D$ components for each constellation block is as good as it can be.

When slicing is used (cf. Fig. 2B), i.e. the data is transmitted in several bursts (or slices) in each frame instead of being distributed over the frame, each frame will be divided into slices of almost equal size. Preferably, all slices should have the same size, apart from one cell. The resulting distribution of the D components for each constellation block is still optimal.

In the following, a preferred embodiment will be described.

Practically, spreading of each FEC block over $N_F$ frames is achieved through interleaving. Fig. 11 shows a preferred embodiment in which the interleaver is a convolutional interleaver and the interleaving is performed over $N_F$=3 frames. Each FEC block is divided into exactly $N_F$ blocks of ideally equal size, referred to as interleaving units (IUs), each of the $N_F$ IUs being fed to one of the $N_F$ interleaver branches. Each branch applies a delay in frames that depends on the branch index. Typically, the branch delay in frames is equal to the zero-based branch index, i.e. 0, 1, and 2 in this example. Therefore, each FEC block will be spread over three adjacent frames, as shown in Fig. 12 for the 4 FEC blocks in frame 1. It is also to be noted that each memory block M of the interleaver must accommodate the number of FEC blocks in a frame, i.e. four FEC blocks in this example.

As mentioned above in conjunction with Fig. 3, the interleaved data for each frame may be further divided into several slices. The effect is that each IU will also be divided into as many slices. Each FEC block will therefore be divided first into IUs then into slices.

Fig. 13 shows an example for 24 complex cells per FEC block (i.e., the same number as in the previous examples), interleaving over four frames, and two slices per frame. In this particular example all slices have the same size, i.e 24/(4*2)=3 cells. If this number is not an integer, then some slices will have one cell more than the others.

Apart from a transmitter that implements the above methods, the present invention also provides a corresponding receiver that mirrors the functionality of the transmitter. A block diagram of such a receiver is illustrated in Fig. 14.

Referring to Fig. 14, the demodulator 280 receives the signal from a radio-frequency RF frontend, which typically comprises an antenna 290, a tuner (not shown), and a down-converter (not shown) to digital baseband. The digital baseband signal is then demodulated by demodulator 280, resulting in a stream of complex symbols (cells) and the associated channel fading coefficients.

The cells belonging to the desired services or programs are extracted from the frame by the frame demapper 270 and deinterleaved by the frame deinterleaver 260. The output of the frame deinterleaver 260 consists of a plurality of FEC blocks per frame, each FEC block being deinterleaved by the cell deinterleaver 250. The D real components of the several constellation blocks mapped onto the complex cells of a FEC block are then extracted from the FEC block by the cell demapper 240 and demodulated by the constellation demapper 220. The latter demodulates D real symbols jointly and produces $B*D$ "soft" bits for each constellation block. The soft bits of each FEC block are then decoded by the forward error correction FEC decoder 210 and fed to the subsequent blocks for further processing.

Summarizing, the present invention provides methods, transmitters, and receivers for digital communication systems with improved time diversity for rotated QAM constellations in two or more dimensions. This is achieved by spreading the components of each constellation block evenly over time so that the temporal distance between components of the same constellation block is maximized. Specific implementations of a permutation that is to be applied to the cells of a forward-error-correction block are disclosed.

## Claims

**1.** A method for transmitting digital data, said method comprising the steps of:

encoding a block of data with a forward error correction code;
mapping the encoded block of data to a sequence of real-valued symbols, the sequence of real-valued symbols being divided into a plurality of *D*-dimensional vectors;
transforming each of the *D*-dimensional vectors by multiplying the vector with an orthogonal matrix, resulting in a plurality of constellation blocks, each constellation block consisting of *D* real-valued transformed symbols;
mapping the real-valued transformed symbols of the plurality of constellation blocks to a sequence of complex symbols such that the *D* real-valued transformed symbols of each constellation block are essentially evenly distributed over the sequence of complex symbols; and
transmitting the sequence of complex symbols.

**2.** A method according to claim 1, wherein the sequence of complex symbols is transmitted such that any two consecutive complex symbols of the sequence of complex symbols are transmitted either simultaneously or in the stated order.

**3.** A method according to claim 1 or 2, wherein the mapping of the real-valued transformed symbols to the sequence of complex symbols is performed such that a minimum distance between complex symbols with symbols of the same constellation block is, with at most one exception, the same for all constellation blocks.

**4.** A method according to any of claims 1 to 3, wherein the step of mapping the real-valued transformed symbols to the sequence of complex symbols is performed by
mapping the *D* real-valued transformed symbols of each constellation block to *D* adjacent complex cells, and

applying a permutation to the sequence of complex symbols, said permutation being equivalent to writing the sequence of complex symbols into a matrix with *D* rows column by column and reading out the complex symbols row by row.

**5.** A method according to any of claims 1 to 3 with D=2, wherein the step of mapping the real-valued transformed symbols to the sequence of complex symbols is performed by
mapping the two real-valued transformed symbols of each constellation block to one complex cell, and
applying a cyclic shift to either the real or the imaginary components of the sequence of complex symbols such that the real and the imaginary components are rotated relative to each other by a certain number of complex symbols, the certain number of complex symbols being equal to half the number of complex symbols within the sequence of complex symbols.

**6.** A method according to any of claims 1 to 5, further comprising the step of dividing the the sequence of complex symbols into a plurality of $N_F$ slices;
wherein the sequence of complex symbols is mapped to $N_F$ consecutive frames such all complex symbols of a given slice are mapped to the same frame.

**7.** A method according to claim 6, wherein a number of complex symbols per slice differs by at most one among the plurality of $N_F$ slices.

**8.** A method for receiving digital data, said method comprising the steps of:

receiving a sequence of complex symbols;
demapping a plurality of constellation blocks from the sequence of complex symbols, each constellation block consisting of *D* real-valued symbols, the *D* real-valued symbols of each constellation block being essentially evenly distributed over the sequence of complex symbols;
demapping an encoded block of data from the sequence of real-valued symbols; and
subjecting the encoded block of data to forward error correction decoding.

**9.** A method according to any of the preceding claims, wherein each real-valued symbol indicates one of a plurality of predefined pulse amplitude modulation symbols.

**10.** A method according to any of the preceding claims, wherein *D* is a power of two, preferably 2 or 4 or 8.

**11.** A transmitter for transmitting digital data, said transmitter comprising:

an encoder (110) for encoding a block of data with a forward error correction code;
a symbol mapper (120) for mapping the encoded block of data to a sequence of real-valued symbols, the sequence of real-valued symbols being divided into a plurality of *D*-dimensional vectors;
a transform unit (130) for transforming each of the *D*-dimensional vectors by multiplying the vector with an orthogonal matrix, resulting in a plurality of constellation blocks, each constellation block consisting of *D* real-valued transformed symbols;
a cell mapper (140) for mapping the real-valued transformed symbols of the plurality of constellation blocks to a sequence of complex symbols;
a cell interleaver (150) for permuting the sequence of complex symbols such that the *D* real-valued transformed symbols of each constellation block are essentially evenly distributed over the permuted sequence of complex symbols; and
a modulator (180) for transmitting the permuted sequence of complex symbols.

**12.** A receiver for receiving digital data, said receiver comprising:

a demodulator (280) for receiving a sequence of complex symbols;
a cell deinterleaver and demapper (250, 240) for demapping a plurality of constellation blocks from the sequence of complex symbols, each constellation block consisting of *D* real-valued symbols, the *D* real-valued symbols of each constellation block being essentially evenly distributed over the sequence of complex symbols;
a constellation demapper (220) for demapping an encoded block of data from the sequence of real-valued symbols; and
a decoder (210) for subjecting the encoded block of data to forward error correction decoding.

Fig. 1

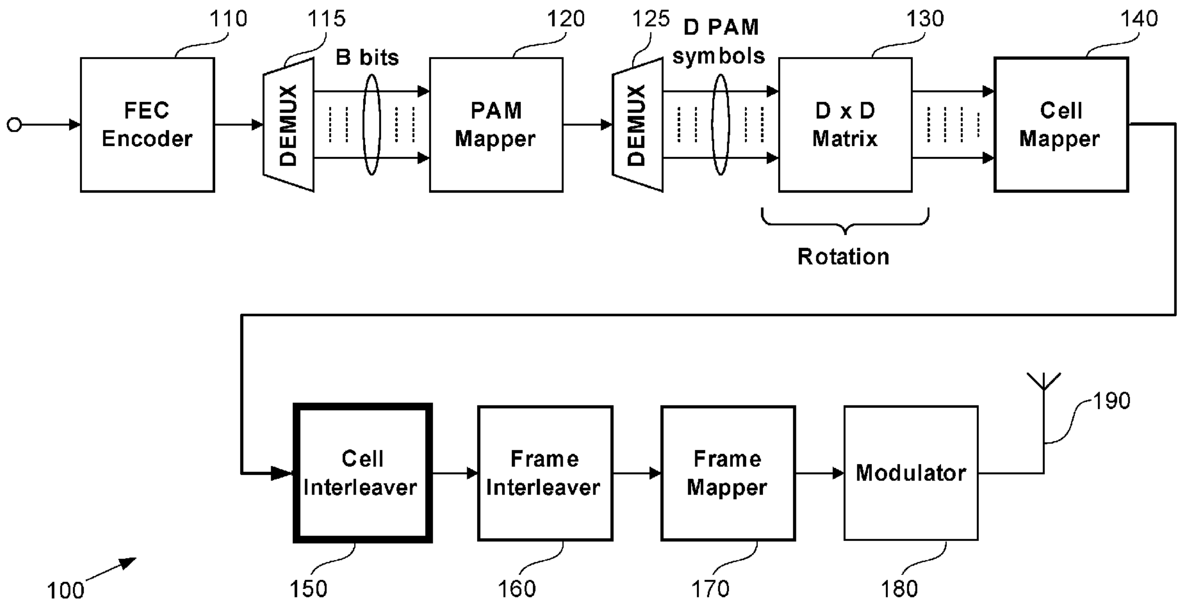
110
115
120
125
130
140
B bits
D PAM symbols
FEC Encoder
DEMUX
PAM Mapper
DEMUX
D x D Matrix
Cell Mapper
Rotation
Cell Interleaver
Frame Interleaver
Frame Mapper
Modulator
190
100
150
160
170
180

Fig. 2A

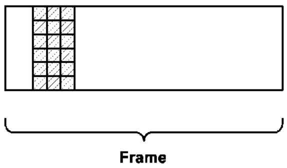


Fig. 2B

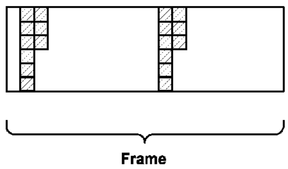


Fig. 2C

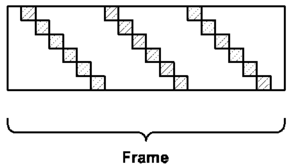


Fig. 2D

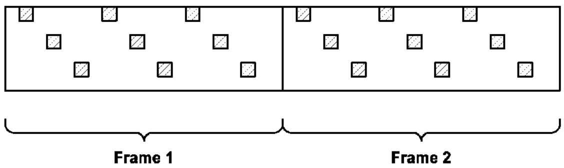


Fig. 2E

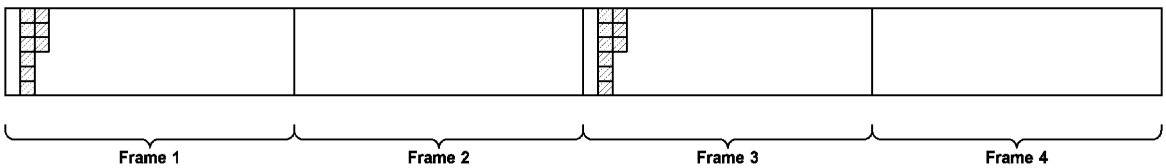

Fig. 3A

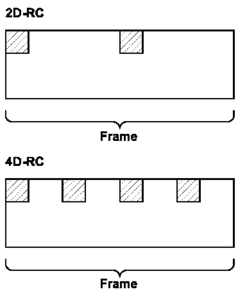


Fig. 3D

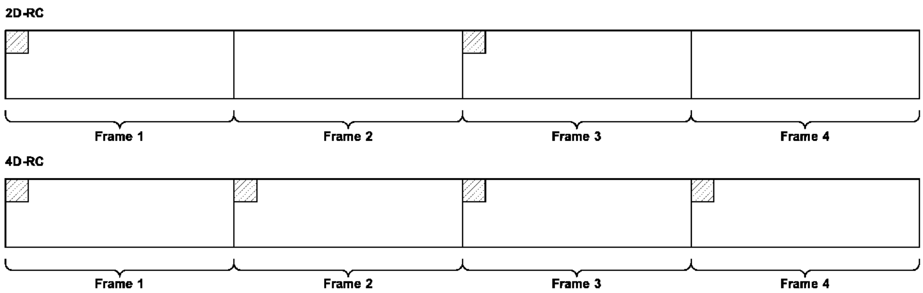


Fig. 3B

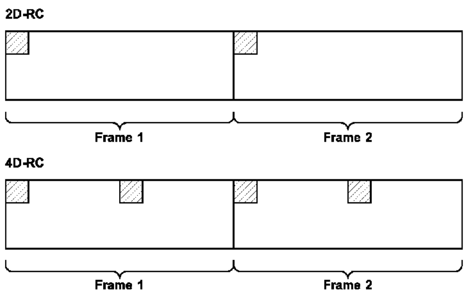


Fig. 3C

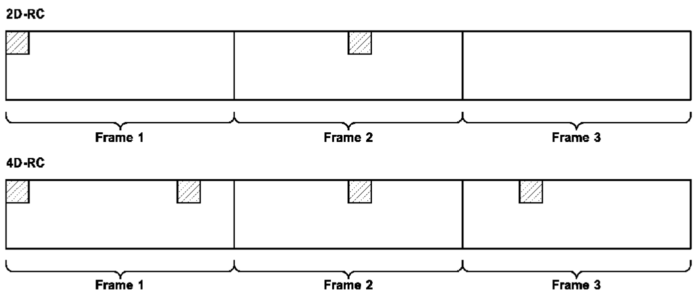

Fig. 4

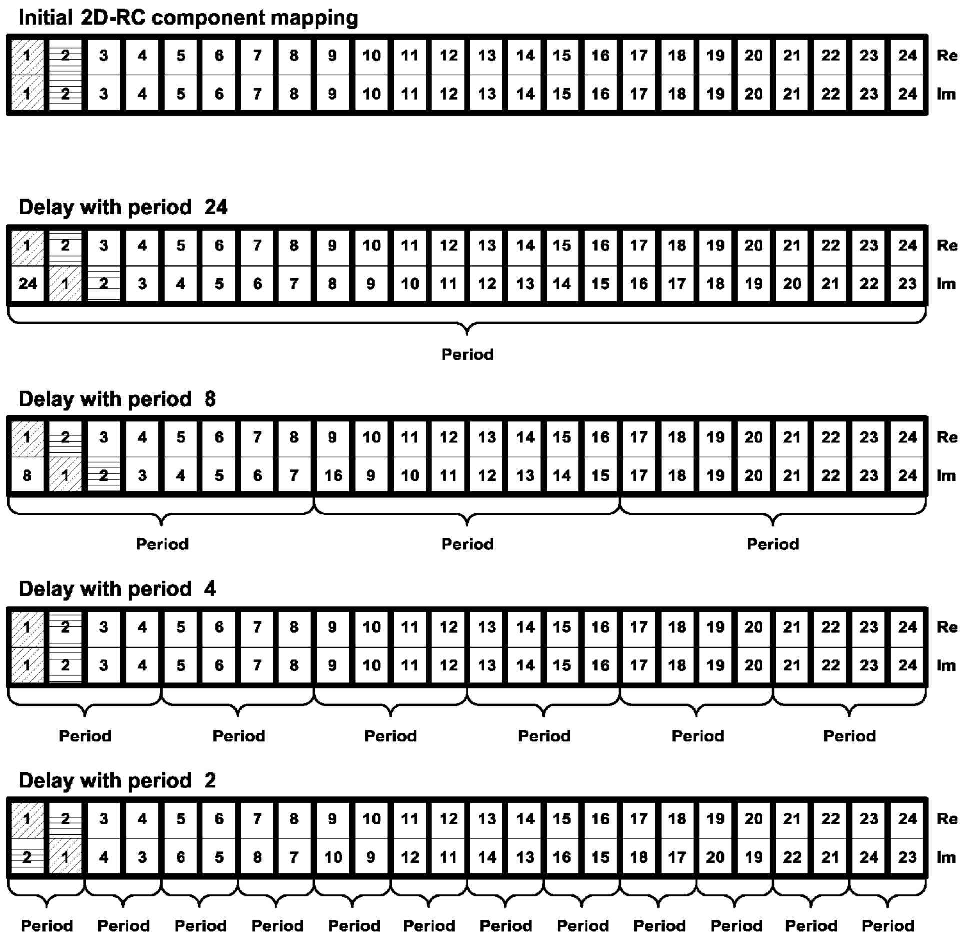
Initial 2D-RC component mapping
1 2 3 4 5 6 7 8 9 10 11 12 13 14 15 16 17 18 19 20 21 22 23 24 Re
1 2 3 4 5 6 7 8 9 10 11 12 13 14 15 16 17 18 19 20 21 22 23 24 Im
Delay with period 24
1 2 3 4 5 6 7 8 9 10 11 12 13 14 15 16 17 18 19 20 21 22 23 24 Re
24 1 2 3 4 5 6 7 8 9 10 11 12 13 14 15 16 17 18 19 20 21 22 23 Im
Period
Delay with period 8
1 2 3 4 5 6 7 8 9 10 11 12 13 14 15 16 17 18 19 20 21 22 23 24 Re
8 1 2 3 4 5 6 7 16 9 10 11 12 13 14 15 17 18 19 20 21 22 23 24 Im
Period
Period
Period
Delay with period 4
1 2 3 4 5 6 7 8 9 10 11 12 13 14 15 16 17 18 19 20 21 22 23 24 Re
1 2 3 4 5 6 7 8 9 10 11 12 13 14 15 16 17 18 19 20 21 22 23 24 Im
Period
Period
Period
Period
Period
Period
Delay with period 2
1 2 3 4 5 6 7 8 9 10 11 12 13 14 15 16 17 18 19 20 21 22 23 24 Re
2 1 4 3 6 5 8 7 10 9 12 11 14 13 16 15 18 17 20 19 22 21 24 23 Im
Period
Period
Period
Period
Period
Period
Period
Period
Period
Period
Period
Period

Fig. 5

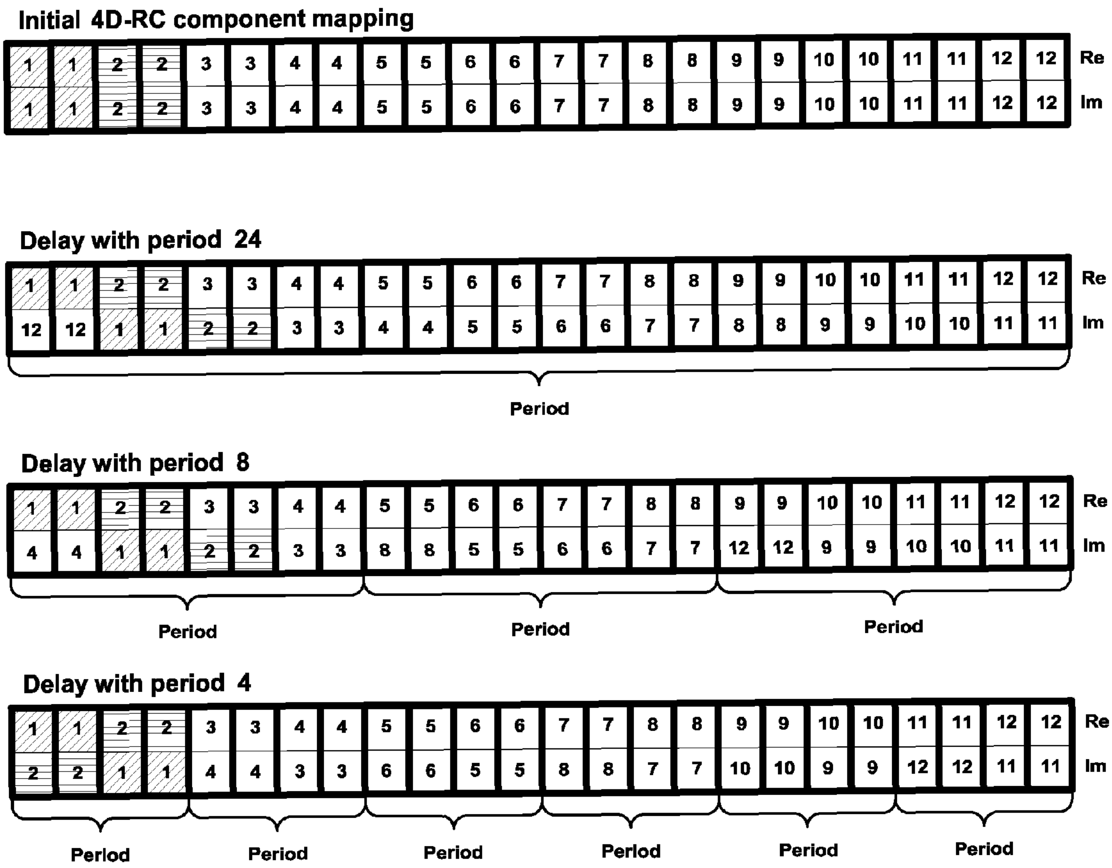
Initial 4D-RC component mapping
Re
Im
Delay with period 24
Period
Delay with period 8
Period
Period
Period
Delay with period 4
Period
Period
Period
Period
Period
Period

Fig. 6

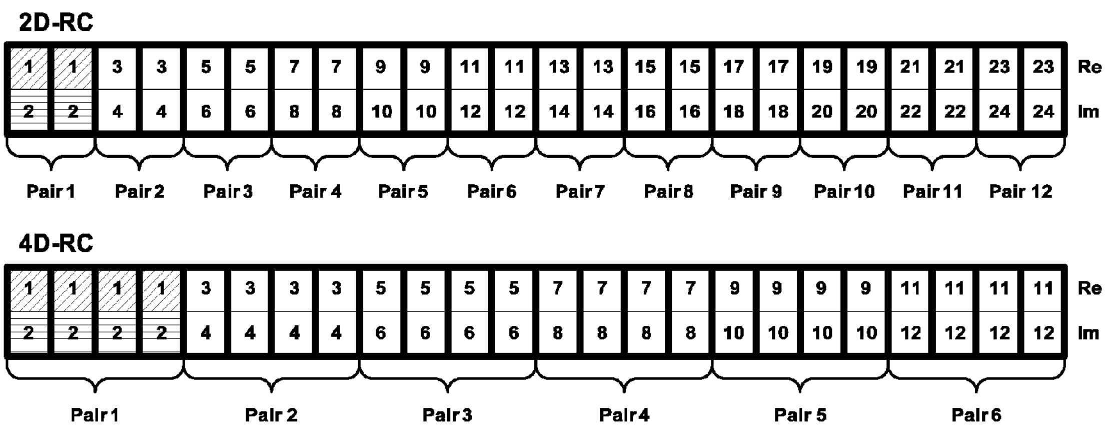
2D-RC
1 1 3 3 5 5 7 7 9 9 11 11 13 13 15 15 17 17 19 19 21 21 23 23 Re
2 2 4 4 6 6 8 8 10 10 12 12 14 14 16 16 18 18 20 20 22 22 24 24 Im
Pair 1 Pair 2 Pair 3 Pair 4 Pair 5 Pair 6 Pair 7 Pair 8 Pair 9 Pair 10 Pair 11 Pair 12
4D-RC
1 1 1 1 3 3 3 3 5 5 5 5 7 7 7 7 9 9 9 9 11 11 11 11 Re
2 2 2 2 4 4 4 4 6 6 6 6 8 8 8 8 10 10 10 10 12 12 12 12 Im
Pair 1 Pair 2 Pair 3 Pair 4 Pair 5 Pair 6

Fig. 7A

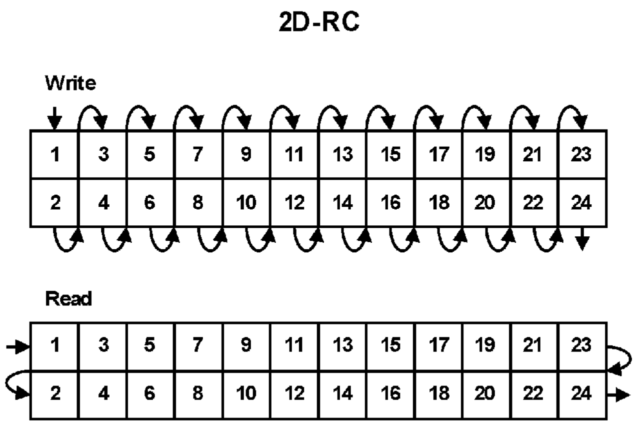
2D-RC
Write
1 3 5 7 9 11 13 15 17 19 21 23
2 4 6 8 10 12 14 16 18 20 22 24
Read
1 3 5 7 9 11 13 15 17 19 21 23
2 4 6 8 10 12 14 16 18 20 22 24

Fig. 7B

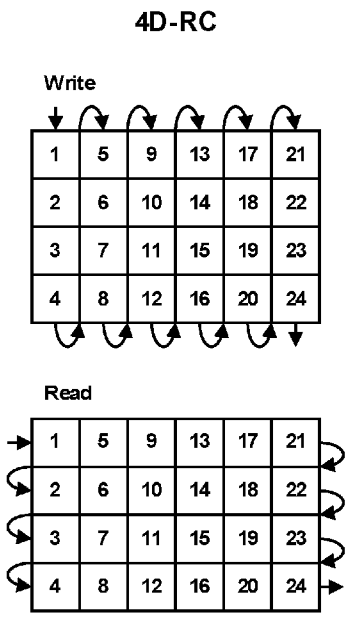
4D-RC
Write
1 5 9 13 17 21
2 6 10 14 18 22
3 7 11 15 19 23
4 8 12 16 20 24
Read
1 5 9 13 17 21
2 6 10 14 18 22
3 7 11 15 19 23
4 8 12 16 20 24

Fig. 8A

2D-RC

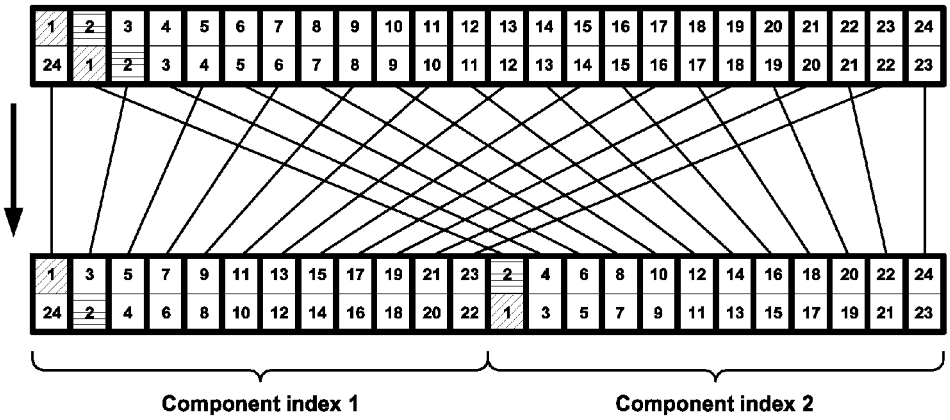


Fig. 8B

4D-RC

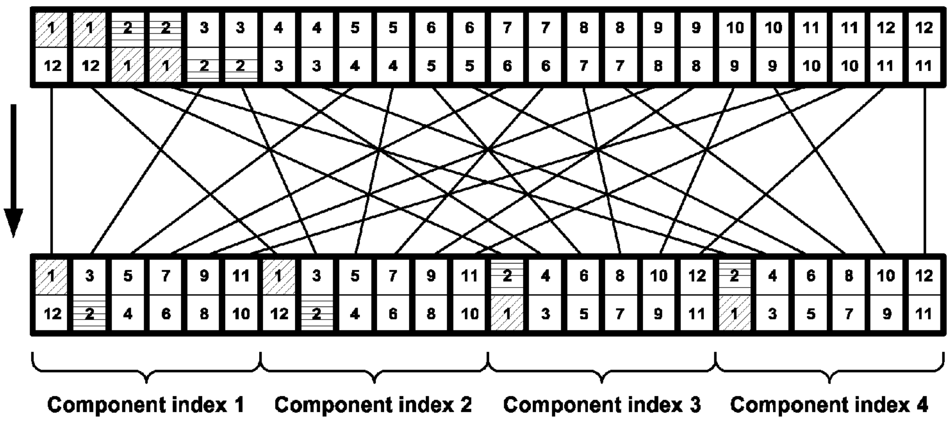

Fig. 9

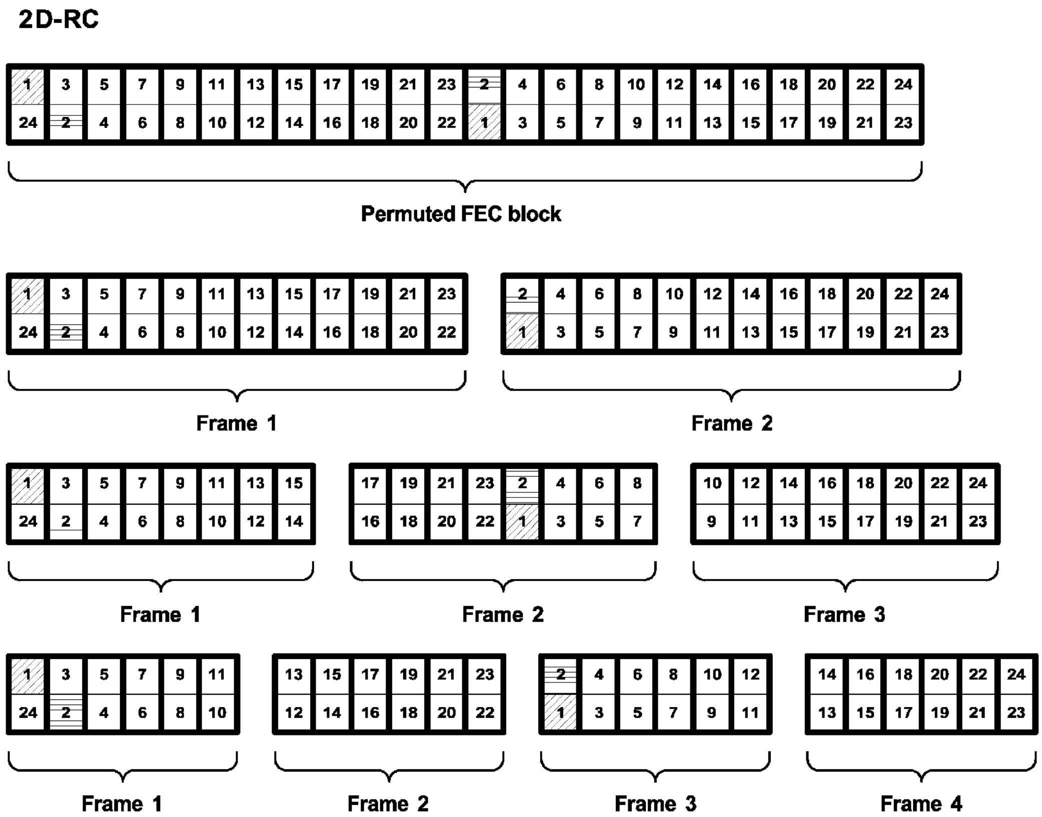
2D-RC
Permuted FEC block
Frame 1
Frame 2
Frame 1
Frame 2
Frame 3
Frame 1
Frame 2
Frame 3
Frame 4

Fig. 10

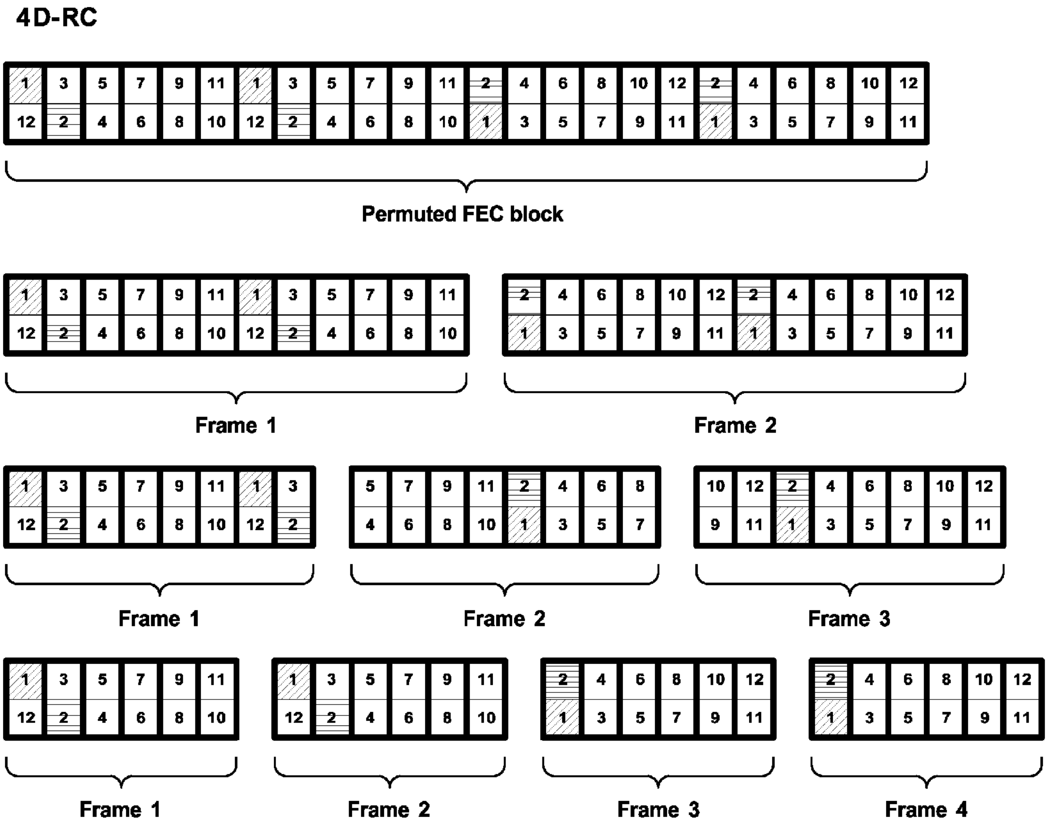
4D-RC
Permuted FEC block
Frame 1
Frame 2
Frame 1
Frame 2
Frame 3
Frame 1
Frame 2
Frame 3
Frame 4

Fig. 11

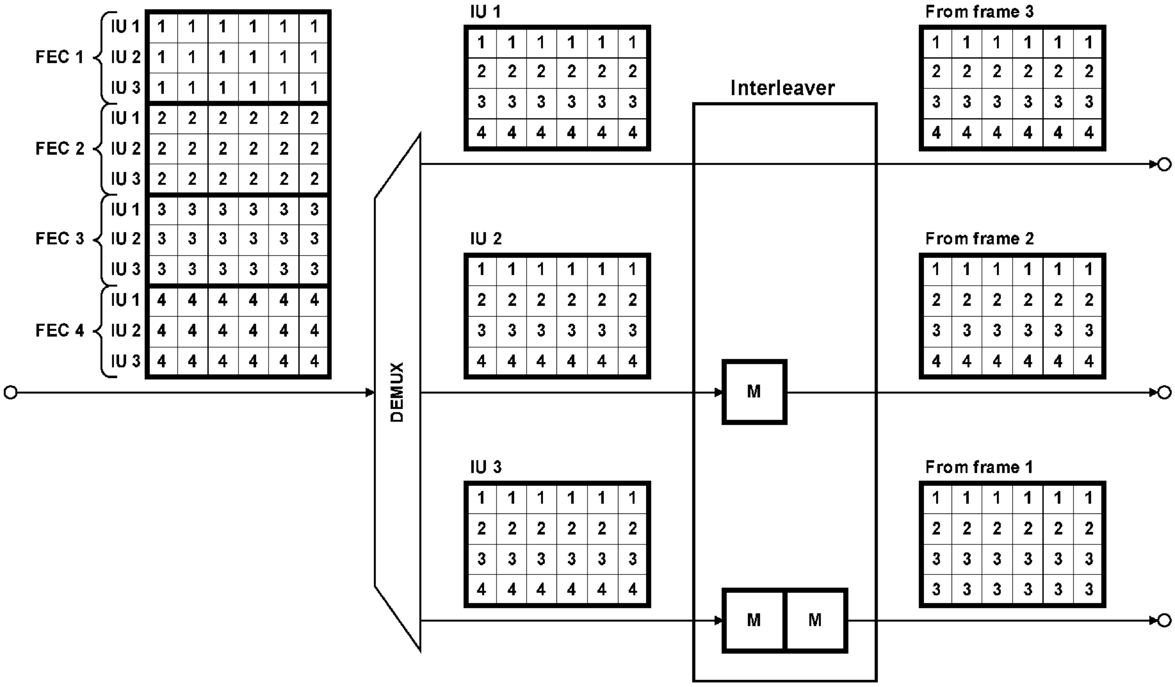
FEC 1
FEC 2
FEC 3
FEC 4
IU 1
IU 2
IU 3
DEMUX
Interleaver
M
M
M
From frame 3
From frame 2
From frame 1

Fig. 12

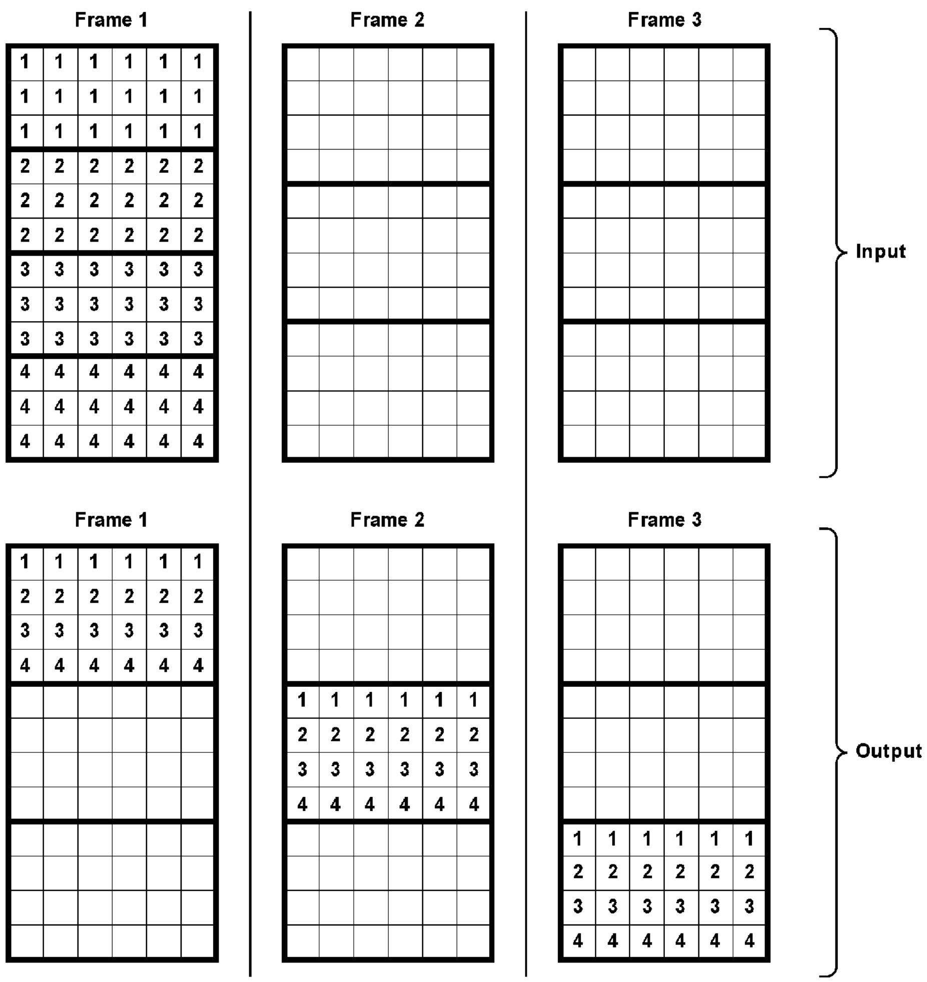

Fig. 13

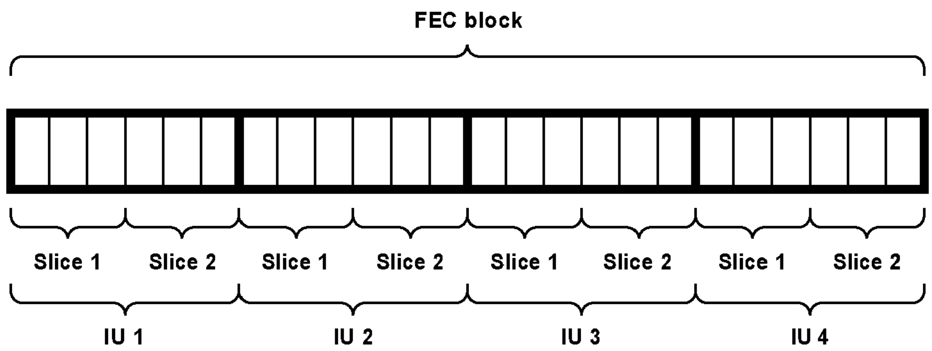
FEC block
Slice 1
Slice 2
Slice 1
Slice 2
Slice 1
Slice 2
Slice 1
Slice 2
IU 1
IU 2
IU 3
IU 4

Fig. 14

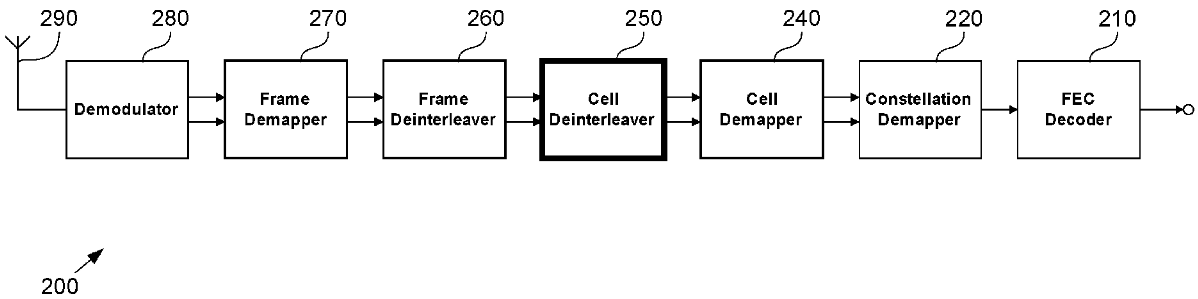
290
280
270
260
250
240
220
210
Demodulator
Frame Demapper
Frame Deinterleaver
Cell Deinterleaver
Cell Demapper
Constellation Demapper
FEC Decoder
200

Europäisches Patentamt
European Patent Office
Office européen des brevets

# EUROPEAN SEARCH REPORT

Application Number
EP 11 18 8627

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Mikel Mendicute, Iker Sobrón, Lorena Martínez and Pello Ochandiano: "DVB-T2: New Signal Processing Algorithmsfor a Challenging Digital VideoBroadcasting Standard", University of Mondragon Digital Video, Floriano da Rango, 1 February 2010 (2010-02-01), pages 185-206, XP002675633, Retrieved from the Internet: URL:http://cdn.intechopen.com/pdfs/8519/InTech-Dvb_t2_new_signal_processing_algorithms_for_a_challenging_digital_video_broadcasting_standard.pdf [retrieved on 2012-05-09] | 1-3,6-12 | INV. H04L1/00 H03M13/27 H04L27/34 |
| A | * sections 2,3 and 7. * | 4,5 | |
| X | WO 2009/069622 A1 (SONY CORP [JP]; YOKOKAWA TAKASHI [JP]; YAMAMOTO MAKIKO [JP]) 4 June 2009 (2009-06-04) * abstract; figures 38-41 * | 1,8,11, 12 | |
| | | | TECHNICAL FIELDS SEARCHED (IPC) |
| A | WU ZHANJI ET AL: "A novel Joint-Coding-Modulation-Diversity OFDM system", MOBILE CONGRESS (GMC), 2010 GLOBAL, IEEE, PISCATAWAY, NJ, USA, 18 October 2010 (2010-10-18), pages 1-6, XP031800622, ISBN: 978-1-4244-9001-1 * section II * | 1-12 | H04L H03M |

-/--

The present search report has been drawn up for all claims

1

| Place of search | Date of completion of the search | Examiner |
|---|---|---|
| Munich | 10 May 2012 | Martínez Martínez, V |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 11 18 8627

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | RUI YE ET AL: "Design of Multiple Turbo-Coded modulation diversity", COMMUNICATIONS, CIRCUITS AND SYSTEMS, 2008. ICCCAS 2008. INTERNATIONAL CONFERENCE ON, IEEE, PISCATAWAY, NJ, USA, 25 May 2008 (2008-05-25), pages 105-108, XP031352888, DOI: 10.1109/ICCCAS.2008.4657738 ISBN: 978-1-4244-2063-6 * sections II. B and II. C. * ----- | 1-12 | |
| | | | TECHNICAL FIELDS SEARCHED (IPC) |

The present search report has been drawn up for all claims

1

| Place of search | Date of completion of the search | Examiner |
|---|---|---|
| Munich | 10 May 2012 | Martínez Martínez, V |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT ON EUROPEAN PATENT APPLICATION NO.** EP 11 18 8627

This annex lists the patent family members relating to the patent documents cited in the above-mentioned European search report.
The members are as contained in the European Patent Office EDP file on
The European Patent Office is in no way liable for these particulars which are merely given for the purpose of information.

10-05-2012

| Patent document cited in search report | Publication date | Patent family member(s) | Publication date |
|---|---|---|---|
| WO 2009069622 A1 | 04-06-2009 | TW 200943735 A | 16-10-2009 |
| | | WO 2009069622 A1 | 04-06-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2288048 A